# EUROPEAN PATENT APPLICATION

(11) **EP 4 092 755 A2**
(43) Date of publication of application: **23.11.2022**
(21) Application number: 22174036.8
(22) Date of filing: 18.05.2022
(51) Int. Cl.: H01L 29/778, H01L 21/338, H01L 29/41, H01L 29/08, H01L 29/20

(54) **SEMICONDUCTOR DEVICE WITH CONDUCTIVE ELEMENT FORMED OVER DIELECTRIC LAYERS AND METHOD OF FABRICATION THEREFOR**

(30) Priority: 20.05.2021 US 202117325995
(71) Applicant: NXP USA, Inc., Austin TX 78735 (US)
(72) Inventor: Grote, Bernhard, 5656AG Eindhoven (NL); Kabir, Humayun, 5656AG Eindhoven (NL); Khalil, Ibrahim, 5656AG Eindhoven (NL); Green, Bruce McRae, 5656AG Eindhoven (NL)
(74) Representative: Miles, John Richard

(57) **Abstract**

An embodiment of a semiconductor device includes a semiconductor substrate (110), a first current-carrying electrode (140), and a second current-carrying electrode (145) formed over the semiconductor, a control electrode (150) formed over the semiconductor substrate between the first current carrying electrode and the second current carrying electrode, and a first dielectric layer (160) disposed over the control electrode, and a second dielectric layer (170) disposed over the first dielectric layer. A first opening is formed in the second dielectric layer, adjacent the control electrode and the second current-carrying electrode, having a first edge laterally adjacent to and nearer the second current-carrying electrode, and a second edge laterally adjacent to and nearer to the control electrode, and a conductive element (180) formed over the first dielectric layer and within the first opening, wherein the portion of the conductive element formed within the first opening forms a first metal-insulator-semiconductor region (187) within the first opening.

## Description

### TECHNICAL FIELD

Embodiments of the subject matter described herein relate generally to semiconductor devices with conductive elements and methods for fabricating such devices.

### BACKGROUND

Semiconductor devices find application in a wide variety of electronic components and systems. High power, high frequency transistors find application in radio frequency (RF) systems and power electronics systems. Gallium nitride (GaN) device technology is particularly suited for these RF power and power electronics applications due to its superior electronic and thermal characteristics. In particular, the high electron velocity and high breakdown field strength of GaN make devices fabricated from this material ideal for RF power amplifiers and high-power switching applications. Field plates are used to reduce gate-drain feedback capacitance and to increase device breakdown voltage in high frequency transistors. Accordingly, there is a need for semiconductor and, in particular, GaN devices with field plates.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross-sectional, side view of an exemplary GaN heterojunction field effect transistor (HFET) in accordance with an embodiment;
FIG. 2 is a cross-sectional, side view of an exemplary GaN HFET in accordance with an embodiment;
FIGs 3 is a process flow diagram of fabrication steps for producing GaN HFET devices of FIGs 1-2, in accordance with embodiments of the method of fabrication; and
FIGs 4, 5, 6A, 6B, 6C, 6D, 7, 8, 9A, 9B, 10A, 10B, 11A, and 11B are cross-sectional, side views of fabrication steps for producing an GaN HFET devices of FIGs 1-2, in accordance with embodiments of the method of fabrication.

### DETAILED DESCRIPTION

In one aspect, an embodiment of a semiconductor device may include a semiconductor substrate that may include an upper surface and a channel. A first current-carrying electrode and a second current-carrying electrode may be formed over the semiconductor substrate, according to an embodiment. The first current-carrying electrode and the second current-carrying electrode may be electrically coupled to the channel, according to an embodiment. In an embodiment, a control electrode may be formed over the semiconductor substrate between the first current carrying electrode and the second current carrying electrode, wherein the control electrode may be electrically coupled to the channel. A first dielectric layer may be disposed over the control electrode and a second dielectric layer may be disposed over the first dielectric layer, according to an embodiment. In an embodiment, a first opening may be formed in the second dielectric layer, adjacent the control electrode, and between the control electrode and the second current-carrying electrode having a first edge laterally adjacent to and nearer the second current-carrying electrode, and a second edge laterally adjacent to and nearer the control electrode. A conductive element may be formed over the first dielectric layer and within the first opening, wherein the portion of the conductive element formed within the first opening may form a first metal-insulator-semiconductor region that includes the portion of the conductive element formed within the first opening, the first dielectric layer, and the semiconductor substrate, according to an embodiment.

In an embodiment, the first dielectric layer may include an etch-stop layer formed over an interlayer dielectric layer, wherein the interlayer dielectric layer may be selected from the group consisting of silicon nitride (SiN), silicon dioxide (SiO₂), silicon oxynitride (SiON), silicon oxide (SiO), hafnium oxide (HfO₂), and tetra-ethyl ortho silicate (TEOS). The first dielectric layer may include a interlayer dielectric layer formed over an etch-stop layer, wherein the interlayer dielectric layer may be selected from the group consisting of SiN, SiO₂, SiON, SiO, HfO₂, and TEOS, according to an embodiment. In an embodiment, the second dielectric layer may be selected from the group consisting of SiN, SiO₂, SiON, SiO, HfO₂, and TEOS.

In an embodiment, a portion of the conductive element formed between the second current-carrying electrode and the first edge of the first opening may form a second metal-insulator-semiconductor region that includes the portion of the conductive element formed between second current-carrying electrode, the second dielectric layer, the first dielectric layer, and the semiconductor substrate.

In an embodiment, a passivation layer may be disposed over the upper surface of the semiconductor substrate between the first dielectric layer and the semiconductor substrate. In an embodiment, the passivation layer may include SiN. In an embodiment, a second opening may be formed in the first dielectric layer, wherein the second opening may overlap at least a portion of the first opening, and wherein at least a portion of the conductive element may be formed within the second opening, wherein the portion of the conductive element formed within the second opening may contact the passivation layer. Passivation openings may be formed in the passivation layer that surround the first current-carrying electrode and the second current-carrying electrode, according to an embodiment. In an embodiment, the first current-carrying electrode may be configured as a source electrode, the second current-carrying electrode may be configured as a drain electrode, the control electrode may be configured as a gate electrode, and the conductive element may be configured as a field plate. According to an embodiment, a lateral distance between the gate electrode and the first opening may be between 0.2 microns and 2 microns. The field plate may be electrically coupled to a potential of the source electrode, according to an embodiment.

In another aspect, the inventive subject matter may include a gallium nitride (GaN) heterojunction field effect transistor (HFET) device that may include a semiconductor substrate that includes a gallium nitride layer, an upper surface, and a channel, according to an embodiment. In an embodiment, a passivation layer may be disposed over the upper surface of the semiconductor substrate. A source electrode and a drain electrode may be formed over the semiconductor substrate within passivation openings formed in the passivation layer, wherein the source electrode and the drain electrode may be electrically coupled to the channel and may be configured to support current flow from the source electrode to the drain electrode, according to an embodiment. In an embodiment, a gate electrode may be formed over the semiconductor substrate between the source electrode and the drain electrode, wherein the gate electrode may be electrically coupled to the channel and may be configured to control current flow from the source electrode to the drain electrode. A first dielectric layer may be disposed over the gate electrode and the passivation layer, according to an embodiment. In an embodiment, a second dielectric layer may be disposed over the first dielectric layer, according to an embodiment. In an embodiment, a first opening may be formed in the second dielectric layer, adjacent the gate electrode, and between the gate electrode and the drain electrode, having a first edge laterally adjacent to and nearer the drain electrode, and a second edge laterally adjacent to and nearer the gate electrode. A field plate may be formed over the second dielectric layer and within at least a portion of the first opening, according to an embodiment. In an embodiment, the portion of the field plate formed within the first opening may form a first metal-insulator-semiconductor region that includes the portion of the field plate within the first opening, the passivation layer, and the semiconductor substrate. The portion of the field plate formed between the drain electrode and the first edge may form a second metal-insulator-semiconductor region that includes the portion of the field plate between the drain electrode and the first edge of the first opening, the second dielectric layer, the first dielectric layer, and the semiconductor substrate, according to an embodiment.

In an embodiment, a second opening may be formed in the first dielectric layer, wherein the second opening may overlap at least a portion of the first opening. At least a portion of the field plate may formed within the second opening, wherein the portion of the field plate formed within the second opening may contact the passivation layer, according to an embodiment.

In yet another aspect, the inventive subject matter may include a method of fabricating a gallium nitride heterojunction field effect transistor device. An embodiment of the method may include forming a semiconductor substrate that includes a gallium nitride layer, a channel, and an upper surface. The method may include forming a passivation layer over the upper surface of the semiconductor substrate, according to an embodiment. An embodiment of the method may include forming passivation openings in the passivation layer. In an embodiment, the method may include forming a source electrode and a drain electrode over the semiconductor substrate within the passivation openings formed in the passivation layer, wherein the source electrode and the drain electrode may be in ohmic contact with the channel and configured to support current flow from the source electrode to the drain electrode. The method may include forming a gate electrode over the semiconductor substrate between the source electrode and the drain electrode, wherein the gate electrode may be electrically coupled to the channel and configured to control current flow from the source electrode to the drain electrode, according to an embodiment. In an embodiment, the method may include forming a first dielectric layer over the gate electrode and the passivation layer. In an embodiment, the method may include forming a second dielectric layer over the first dielectric layer. The method may include forming a first opening in the second dielectric layer, adjacent the gate electrode and between the gate electrode and the drain electrode, having a first edge laterally adjacent to and nearer the second current-carrying electrode, and a second edge laterally adjacent to and nearer the gate electrode, according to an embodiment. In an embodiment, the method may include forming a field plate over the second dielectric layer wherein at least a portion of the field plate is formed within the first opening. The method may include forming an active region by defining an isolation region within the semiconductor substrate, according to an embodiment. In an embodiment, forming the first dielectric layer may include forming an etch-stop layer. According to an embodiment, the method may include forming a second opening in the first dielectric layer, wherein at least a portion of the second opening may overlap the first opening. In an embodiment, the method may include forming a portion of the field plate within the second opening. Forming the passivation layer may include forming an etch-stop layer, according to an embodiment of the method.

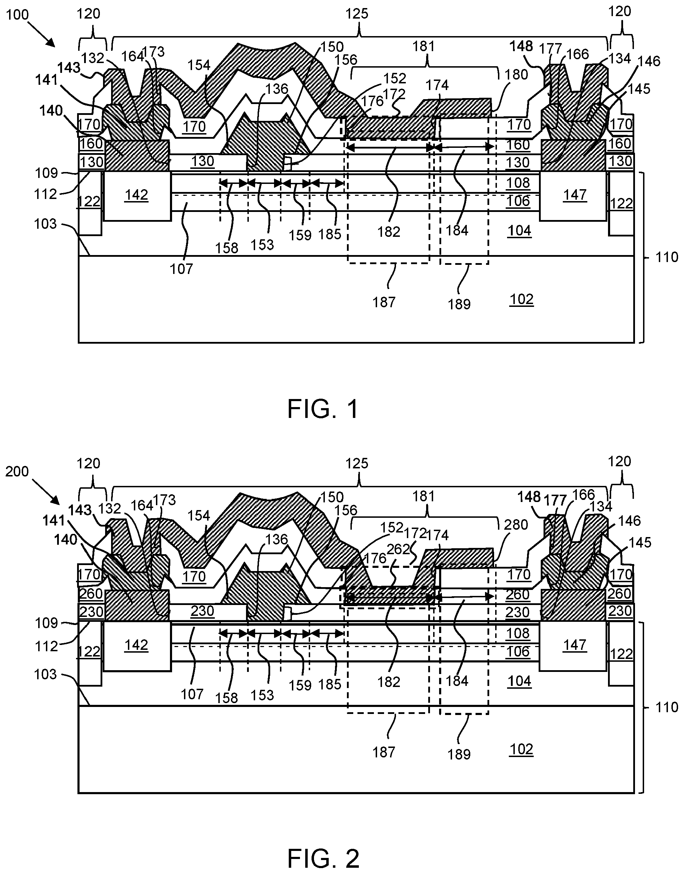

FIG. 1 is a cross-sectional, side view of an exemplary GaN heterojunction field effect transistor (HFET) device 100, in accordance with an embodiment. In an embodiment, the GaN HFET device 100 may include a semiconductor substrate 110, one or more isolation regions 120, an active region 125, a passivation layer 130, a source electrode (generally "first current-carrying electrode") 140, a drain electrode (generally "second current-carrying electrode") 145, a gate electrode 150 (generally "control electrode"), a first dielectric layer 160, a second dielectric layer 170, and a field plate (generally "conductive element") 180. As described more fully below, the GaN HFET device 100 may be substantially contained within the active region 125 defined by the isolation regions 120, with the passivation layer 130, the source electrode 140, the drain electrode 145, the gate electrode 150, the first dielectric layer 160, the second dielectric layer 170, and the field plate 180 disposed over the semiconductor substrate 110.

In an embodiment, the semiconductor substrate 110 may include a host substrate 102, a buffer layer 104 disposed over the host substrate 102, a channel layer 106 disposed over the buffer layer 104, a barrier layer 108 disposed over the channel layer 106, and a cap layer 109 disposed over the barrier layer 108. In an embodiment, the host substrate 102 may include silicon carbide (SiC). In other embodiments, the host substrate 102 may include other materials such as sapphire, silicon (Si), GaN, aluminum nitride (AlN), diamond, poly-SiC, silicon on insulator, gallium arsenide (GaAs), indium phosphide (InP), and other substantially insulating or high resistivity materials. A nucleation layer (not shown) may be formed on an upper surface 103 of the host substrate 102 between the buffer layer 104 and the host substrate 102. In an embodiment, the nucleation layer may include A1N. The buffer layer 104 may include one or more group III-N semiconductor layers and may be supported by the host substrate 102. The semiconductor layer(s) of the buffer layer 104 may include an epitaxially grown group III-nitride epitaxial layer. The group-III nitride epitaxially layer(s) that make up the buffer layer 104 may be nitrogen (N)-face or gallium (Ga)-face material, for example. In other embodiments, the semiconductor layers of the buffer layer 104 may not be epitaxially grown. In still other embodiments, the semiconductor layers of the buffer layer 104 may include Si, GaAs, InP, or other suitable materials.

In an embodiment, the buffer layer 104 may be grown epitaxially over the host substrate 102. The buffer layer 104 may include at least one AlGaN mixed crystal layer having a composition denoted by AlxGai-xN with an aluminum mole fraction, X, that can take on values between 0 and 1. The total thickness of the buffer layer 104 with all of its layers may be between about 200 angstroms and about 100,000 angstroms although other thicknesses may be used. A limiting X value of 0 yields pure GaN while a value of 1 yields pure AlN. An embodiment may include a buffer layer 104 disposed over the host substrate and nucleation layer (not shown). The buffer layer 104 may include additional AlxGai-xN layers. The thickness of the additional AlxGai-xN layer(s) may be between about 200 angstroms and about 50,000 angstroms, though other thicknesses may be used. In an embodiment, the additional AlxGai-xN layers may be configured as GaN (X=0) where the AlxGai-xN is not intentionally doped (NID). The additional AlxGai-xN layers may also be configured as one or more GaN layers where the one or more GaN layers are intentionally doped with dopants that may include iron (Fe), chromium (Cr), carbon (C), or other suitable dopants that render the buffer layer 104 substantially insulating or high resistivity. The dopant concentration may be between about 10¹⁶ cm⁻³ and 10¹⁹ cm⁻³ though other higher or lower concentrations may be used. The additional AlₓGa₁₋ₓN layers may be configured with X=0.01 to 0.10 where the AlₓGa₁₋ₓN is NID or, alternatively, where the AlₓGa₁₋ₓN is intentionally doped with Fe, Cr, C, or other suitable dopant species. In other embodiments (not shown), the additional layers may be configured as a superlattice where the additional layers include a series of alternating NID or doped AlₓGa₁₋ₓN layers where the value of X takes a value between 0 and 1. In still other embodiments, the buffer layer 104 may also include one or more indium gallium nitride (InGaN) layers, with composition denoted In_{Y}Ga_{1-Y}N, where Y, the indium mole fraction, may take a value between 0 and 1. The thickness of the InGaN layer(s) may be between about 5 angstroms and about 2000 angstroms, though other thicknesses may be used.

In an embodiment, a channel layer 106 may be formed over the buffer layer 104. The channel layer 106 may include one or more group III-N semiconductor layers and may be supported by the buffer layer 104. The channel layer 106 may include an AlxGai-xN layer where X takes on values between 0 and 1. In an embodiment, the channel layer 106 may be configured as GaN (X=0), although other values of X may be used without departing from the scope of the inventive subject matter. The thickness of the channel layer 106 may be between about 50 angstroms and about 10,000 angstroms though other thicknesses may be used. The channel layer 106 may be NID or, alternatively, may include Si, germanium (Ge), C, Fe, Cr, or other suitable dopants. The dopant concentration may be between about 10¹⁵ cm⁻³ and about 10¹⁹ cm⁻³ though other higher or lower concentrations may be used. In other embodiments, the channel layer 106 may include NID or doped In_{Y}Ga_{1-Y}N, where Y, the indium mole fraction, may take a value between 0 and 1.

A barrier layer 108 may be formed over the channel layer 106 in accordance with an embodiment. The barrier layer 108 may include one or more group III-N semiconductor layers and is supported by the channel layer 106. In some embodiments, the barrier layer 108 may have a larger bandgap and larger spontaneous polarization than the channel layer 106 and, when the barrier layer 108 is in direct contact with the channel layer 106, a channel 107 may be created in the form of a two-dimensional electron gas (2-DEG) within the channel layer 106 near the interface between the channel layer 106 and barrier layer 108. In addition, strain between the barrier layer 108 and channel layer 106 may cause additional piezoelectric charge to be introduced into the 2-DEG and channel 107. The barrier layer 108 may include at least one NID AlₓGa₁₋ₓN layer where X takes on values between 0 and 1. In some embodiments, X may take a value of 0.1 to 0.35, although other values of X may be used. The thickness of the barrier layer 108 may be between about 50 angstroms and about 1000 angstroms though other thicknesses may be used. The barrier layer 108 may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used. In an embodiment, an additional AlN interbarrier layer (not shown) may be formed between the channel layer 106 and the barrier layer 108, according to an embodiment. The AlN interbarrier layer may increase the channel charge and improve the electron confinement of the resultant 2-DEG. In other embodiments, the barrier layer 108 may include indium aluminum nitride (InAIN) layers, denoted In_{Y}Al_{1-Y}N, where Y, the indium mole fraction, may take a value between about 0.1 and about 0.2 though other values of Y may be used. In the case of an InAIN barrier, the thickness of the barrier layer 108 may be between about 30 angstroms and about 2000 angstroms though other thicknesses may be used. In the case of using InAIN to form the barrier layer 108, the InAlN may be NID or, alternatively, may include Si, Ge, C, Fe, Cr, or other suitable dopants. The dopant concentration may be between about 10¹⁶ cm⁻³ and about 10¹⁹ cm⁻³ though other higher or lower concentrations may be used.

In an embodiment illustrated in FIG. 1, a cap layer 109 may be formed over the barrier layer 108. The cap layer 109 presents a stable surface for the semiconductor substrate 110 and serves to protect the surface of the semiconductor substrate 110 from chemical and environmental exposure incidental to wafer processing. The cap layer 109 may include one or more group III-N semiconductor layers and is supported by the barrier layer 108. In an embodiment, the cap layer 109 may include GaN. The thickness of the cap layer 109 may be between about 5 angstroms and about 100 angstroms though other thicknesses may be used. The cap layer 109 may be NID or, alternatively, may include Si, Ge, C, Fe, Cr, or other suitable dopant(s). The dopant concentration may be between about 10¹⁶ cm⁻³ and 10¹⁹ cm⁻³ though other higher or lower concentrations may be used. Without departing from the scope of the inventive subject matter, it should be appreciated that the choice of materials and arrangement of layers to form semiconductor substrate 110 is exemplary. It should be appreciated that the inclusion of the host substrate 102, the buffer layer 104, the channel layer 106, the barrier layer 108, and the cap layer 109 into the semiconductor substrate 110 is exemplary and that the function and operation of the various layers may be combined and may change depending on the materials used in any specific embodiment. For example, in some embodiments (not shown), the cap layer 109 may be omitted. In other embodiments using N-polar materials (not shown), the channel layer 106 may be disposed over the barrier layer 108 to create a 2-DEG and channel 107 directly beneath an optional cap and the gate electrode 150. Still further embodiments may include semiconductor layers formed from materials including GaAs, gallium oxide (Ga₂O₃) aluminum gallium arsenide (AlGaAs), indium gallium arsenide (InGaAs), and aluminum indium arsenide (AlInAs) to form the semiconductor substrate 110.

One or more isolation regions 120 may be formed in the semiconductor substrate 110 to define an active region 125 above and along the upper surface 103 of the host substrate 102, according to an embodiment. The isolation regions 120 may be formed via an implantation procedure configured to damage the epitaxial and/or other semiconductor layers to create high resistivity regions 122 of the semiconductor substrate 110, rendering the semiconductor substrate 110 high resistivity or semi-insulating in those high resistivity regions 122 while leaving the crystal structure intact in the active region 125. In other embodiments, the isolation regions 120 may be formed by removing one or more of the epitaxial and/or other semiconductor layers of the semiconductor substrate 110 rendering the remaining layers of the semiconductor substrate 110 semi-insulating and leaving behind active region "mesas" surrounded by high resistivity or semi-insulating isolation regions (not shown). In still other embodiments, the isolation regions 120 may be formed by removing one or more of the epitaxial and/or other semiconductor layers of the semiconductor substrate 110 and then using ion implantation to damage and further enhance the semi-insulating properties of the remaining layers of the semiconductor substrate 110 and leaving behind active region 125 "mesas" surrounded by high resistivity or semi-insulating isolation regions 120 that have been implanted (not shown). In an embodiment, the passivation layer 130 may be formed over the active region 125 and isolation regions 120. In an embodiment, the passivation layer 130 may be formed from one or more suitable materials including SiO₂, SiN, SiON, aluminum oxide (Al₂O₃), AlN, and HfO₂, though other substantially insulating materials may be used. In an embodiment, the passivation layer 130 may have a thickness of between 200 angstroms and 1000 angstroms. In other embodiments, the passivation layer 130 may have a thickness of between 50 angstroms and 10000 angstroms, though other thicknesses may be used.

In an embodiment, the source electrode 140 and the drain electrode 145 may be formed over and contact source and drain regions 142, 147 formed in semiconductor substrate 110 in the active region 125. The source electrode 140 and the drain electrode 145 may be formed inside a source opening 132 and a drain opening 134 (more generally "passivation openings") formed in the passivation layer 130 and may be formed from one or more conductive layers. In some embodiments, ion implantation may be used to form an ohmic contact to the channel 107 by creating source and drain regions 142, 147. In an embodiment, the one or more conductive layers used to form source and drain electrodes 140, 145 may include Ti, Au, Al, molybdenum (Mo), nickel (Ni), Si, Ge, platinum (Pt), or other suitable materials. In an embodiment, the source electrode 140 and the drain electrode 145 may be formed over and in contact with the cap layer 109. In other embodiments (not shown), one or both of the source electrode 140 and the drain electrode 145 may be recessed through the cap layer 109 and extend partially through the barrier layer 108. In an embodiment, the source electrode 140 and the drain electrode 145 may be formed from a multi-layer stack. In an embodiment, the multi-layer stack used to form source electrode 140 and drain electrode 145 may include an adhesion layer and one or more layers, that when annealed, allow an ohmic contract to form between the channel 107 and the source and drain regions 142, 147. In an embodiment, the adhesion layer may include titanium (Ti), tantalum (Ta), silicon (Si), or other suitable materials. In an embodiment, the adhesion layer may have a work function that is below 4.5 electron-volts.

In an embodiment, the gate electrode 150 may be formed over the semiconductor substrate 110 in the active region 125. The gate electrode 150 may include a vertical stem 152, a first protruding region 154 coupled to the vertical stem 152, over the passivation layer 130 and toward the source electrode 140, according to an embodiment. In an embodiment, a second protruding region 156 may couple to the vertical stem 152 and may be formed over the passivation layer 130 and toward the drain electrode 145, according to an embodiment. In an embodiment, the gate electrode 150 may be electrically coupled to the channel 107 through the cap layer 109 and barrier layer 108. Changes to the electric potential applied to the gate electrode 150 may shift the quasi Fermi level for the barrier layer 108 with respect to the quasi-Fermi level for the channel layer 106 and thereby modulate the electron concentration in the channel 107 within the semiconductor substrate 110 under the gate electrode 150. Schottky materials such as nickel (Ni), palladium (Pd), platinum (Pt), iridium (Ir), and copper (Cu), titanium-tungsten (TiW), titanium-tungsten nitride (TiWN), may be combined with one or more of low stress conductive materials such as Au, Al, Cu, poly Si, or other suitable material(s) in a metal stack to form a gate electrode 150 for a low-loss Schottky gate electrode 150 electrically coupled to channel 107, according to an embodiment. In an embodiment, the gate electrode 150 may be formed, wherein the vertical stem 152 may be formed within a gate opening 136 in the passivation layer 130.

In an embodiment, the gate electrode 150 may be characterized by a gate length 153 within the gate opening 136 and first and second protruding region lengths 158 and 159 where the first and second protruding regions 154 and 156 overlay the passivation layer 130. In an embodiment, the gate length 153 may be between about 0.1 microns and about 1 micron. In other embodiments, the gate length 153 may be between about 0.01 microns and about 2 microns, though other suitable dimensions may be used. In an embodiment, the first protruding region length 158 may be between about 0.1 microns and about 0.5 microns. In other embodiments, the first protruding region length 158 may be between about 0.05 microns and 2 microns, though other suitable dimensions may be used. In an embodiment, a second protruding region length 159 may be between about 0.1 microns and about 0.5 microns. In other embodiments, the second protruding region length 159 may be between 0.1 microns and 2 microns, though other suitable lengths may be used.

Without departing from the scope of the inventive subject matter, numerous other embodiments may be realized. For example, the exemplary embodiment of FIG. 1 depicts the gate electrode 150 as T-shaped with the vertical stem 152 and first and second protruding regions 154 and 156 disposed over the passivation layer 130. In other embodiments, the gate electrode 150 may have a square shape with no protruding regions (e.g. first and second protruding regions 154 and 156) over the passivation layer 130. In other embodiments (not shown), the gate electrode 150 may be recessed through the cap layer 109 and extend partially into the barrier layer 108, increasing the electrical coupling of the gate electrode 150 to the channel 107 through the barrier layer 108. In other embodiments (not shown), the cap layer 109 may be omitted and the gate electrode 150 may contact the barrier layer directly (not shown). In still other embodiments, the gate electrode 150 may be disposed over a gate dielectric that is formed between the gate electrode 150 and the semiconductor substrate 110 to form a metal insulator semiconductor field effect transistor (MISFET) device (not shown).

In an embodiment, the first dielectric layer 160 may disposed over the gate electrode 150, according to an embodiment. In an embodiment, the first dielectric layer 160 may include an etch-stop layer formed over an inter-layer dielectric (ILD) layer. In an embodiment, the etch-stop layer may include one of SiN, Al₂O₃, SiO₂, HfO₂, indium tin oxide (ITO), diamond, poly-diamond, aluminum nitride (AlN), boron nitride (BN), silicon carbide (SiC), or a combination of these or other insulating materials. In an embodiment, the thickness of the interlayer dielectric layer may be between about 50 angstroms and about 10,000 angstroms in thickness, although other thinner or thicker values may be used. According to an embodiment, the total thickness of the layers used to form the first dielectric layer 160 may be between about 100 angstroms and about 15,000 angstroms in thickness, although other thickness values may be used. The etch-stop layer and the ILD layer may be configured in a way that layers formed above the first dielectric layer 160 (e.g. second dielectric 170) may be etched without significantly etching the first dielectric layer 160 by stopping the etch of the first dielectric layer 160 on the etch-stop layer, according to an embodiment. For example, and in embodiment, the etch-stop layer may include one or more Al-containing layers, e.g., Al₂O₃ and AlN,while the ILD layer may include one or more of SiO₂, TEOS, SiN, and the ILD layer may include one or more of SiO₂, TEOS, SiN. In this embodiment, fluorine (F)-based chemistry may etch dielectric layers formed above the first dielectric layer 160 (e.g. SiN within the second dielectric layer 170) while stopping on the Al-containing etch-stop layer of the first dielectric layer 160.

Without departing from the inventive subject matter, in other embodiments, the first dielectric layer 160 may be formed from a single layer. In these embodiments, the first dielectric layer 160 may not include an etch-stop layer. In still other embodiments, the first dielectric layer 160 may include a single layer configured as an etch-stop layer.

Source and drain openings 164, 166 may be formed in the first dielectric layer 160 to allow contact to the source electrode 140 and the drain electrode 145, according to an embodiment. In an embodiment, additional metallization regions 141, 146 may be formed within the source and drain openings 164, 166 and over the source and drain electrodes 140, 145. In an embodiment, the additional metallization regions 141, 146 may include one or more first layer(s) that act as an adhesion layer and/or barrier layer and one or more additional layer(s) that act as conductive layer(s). The first layers may include one or more adhesion layers that include, Ti, TiW, TiWN, chromium (Cr) or other suitable materials, according to an embodiment. In an embodiment, the first layer(s) may also include one or more barrier layer(s), e.g., Pt, Pd, W, Ni, or other suitable material(s) formed over the one or more adhesion layer(s). The additional layer(s) may include one or more conductive layer(s), e.g. , Au, Al, Cu, poly Si, or other suitable materials formed over the adhesion and barrier layer(s), according to an embodiment. In an embodiment, the thickness of the first layers, including the adhesion layer(s) and/or the barrier layer(s) may be between about 100 angstroms and about 10,000 angstroms, although thicker or thinner layers may be used. In an embodiment, the thickness of the additional layers, including the conductive layer(s) may be between about 100 angstroms and about 100,000 angstroms, although thicker or thinner layers may be used. In one example embodiment, the additional metallization regions 141, 146 may include a Ti adhesion layer that contacts the source and drain electrodes 140, 145, a Pt barrier layer formed over the Ti adhesion layer, and a Au conductive layer formed over the Pt barrier layer. Without departing from the scope of the inventive subject matter, and in other embodiments, metallization 141, 146 may include more or fewer layers with the same or different material than this example embodiment.

A second dielectric layer 170 may be disposed over the first dielectric layer 160, according to an embodiment. In an embodiment, the second dielectric layer 170 may include one or more of SiN, Al2O₃, SiO₂, TEOS, HfO₂, ITO, diamond, poly-diamond, AlN,BN, SiC, or a combination of these or other insulating materials. In an embodiment, the thickness of the second dielectric layer 170 may be between about 50 angstroms and about 10,000 angstroms in thickness, although other thinner or thicker values may be used. In some embodiments, the second dielectric layer 170 may be formed from a single layer. In other embodiments, the second dielectric layer 170 may include multiple layers.

In an embodiment, a first opening 172 may be formed in the second dielectric layer 170, adjacent the gate electrode 150, and between the gate electrode 150 and the drain electrode 145. The first opening 172 may include a first edge 174 adjacent to the drain electrode 145 and a second edge 176 adjacent to the gate electrode 150. In an embodiment, source and drain openings 173, 177 may be formed in the second dielectric layer adjacent the first opening. In an embodiment, the first opening 172 may expose the first dielectric layer 160.

In an embodiment, the field plate 180 may be disposed over the first dielectric layer 160 within and outside the first opening 172, over the second dielectric layer 170 outside the first opening 172. In an embodiment, the field plate 180 may be formed proximate the gate electrode 150 adjacent the drain electrode 145. In an embodiment, the field plate 180 may be coupled to the source electrode 140. In an embodiment, second additional metallization regions 143, 148 may be formed using the same conductive layer(s) as the field plate 180. In an embodiment, the second additional metallization regions 143, 148 may be coupled to the source and drain electrodes 140, 145 through the additional metallization regions 141, 146. In an embodiment, the field plate metal may include one or more adhesion and conductive metal layers. In an embodiment, the adhesion layer(s) may be a bottom layer, with conductive layer(s) formed over the adhesion layer(s). The adhesion layer(s) may include one of Ti, Ni, Cr or other suitable adhesion layer material(s). The adhesion layer(s) may be between about 50 and about 2,000 angstroms in thickness, although other thickness values may be used. The conductive layer(s) may include Cu, Au, Al, or Ag, although other suitable materials may be used. The conductive layer(s) may be between about 200 and about 40,000 angstroms in thickness, although other thickness values may be used.

In an embodiment, a field plate drain extension 181 may include the portion of the field plate 180 formed within the first opening 172 and that portion of field plate 180 formed over a portion of second dielectric layer 170 between the first opening 172 and the drain electrode 145. The portion of the field plate 180 formed within the first opening 172 may be characterized by a first field plate drain extension length 182. In an embodiment, the first field plate drain extension length 182 may characterize the overlap of the field plate 180 between the first edge 174 and the second edge 176 of the first opening 172, over the first dielectric layer 160, and the passivation layer 130. In an embodiment, the first field plate drain extension length 182 may be between about 0.2 microns and about 2 microns. In other embodiments, the first field plate drain extension length 182 may be between about 0.1 and about 10 microns. Without departing from the scope of the inventive subject matter, the first field plate extension length 182 may have other longer or shorter lengths. A second field plate drain extension length 184 characterizes the overlap of the field plate 180 over the second dielectric layer 170, the first dielectric layer 160 and the passivation layer 130 between the first edge 174 of the first opening 172 and the drain electrode 145, according to an embodiment. In an embodiment, the second field plate drain extension length 184 may be between about 0.2 microns and about 2 microns. In other embodiments, the second field plate drain extension length 184 may be between about 0.1 and about 10 microns. Without departing from the scope of the inventive subject matter, the second field plate extension length 184 may have other longer or shorter lengths. In an embodiment, the field plate 180 may be coupled to the same potential as the source electrode 140 or to a ground potential. In an embodiment, the field plate 180 may be formed within the first opening 172 and, outside the first opening 172, run over the first dielectric layer 160 and the second dielectric layer 170 and over the gate electrode 150. The field plate 180 may be electrically coupled to the source electrode 140 via through opening 173 (e.g. though additional metallization 141). In an embodiment, the field plate 180 may be separated from the gate by the combined thicknesses of the first dielectric layer 160 and the second dielectric layer 170. According to an embodiment, a lateral distance 185 between the gate electrode and the first opening may be between 0.2 microns and 2 microns. In other embodiments, the field plate 180 may be coupled to the gate electrode 150. In other, further embodiments, the field plate 180 may be coupled to an arbitrary potential.

In an embodiment, the field plate 180 may create a first metal-insulator-semiconductor region 187 and a second metal-insulator-semiconductor region 189. In an embodiment, the first metal-insulator-semiconductor region 187 may include portions of the field plate 180, the first dielectric layer 160, the passivation layer 130, and the semiconductor substrate 110 within the first opening 172, characterized by the first field plate drain extension length 184, as described previously. The second metal-insulator-semiconductor region 189 may include the field plate 180, the second dielectric layer 170, the first dielectric layer 160, the passivation layer 130, and the semiconductor substrate 110 formed over the second dielectric layer 170, characterized by the second field plate drain extension length 184, as described previously, and according to an embodiment. The first and second metal-insulator-semiconductor regions 187, 189 may act as part of the active device and have first and second threshold voltages, dependent on the thicknesses of the passivation layer 130, first dielectric layer 160, second dielectric layer 170, the amount of charge in the channel 107, and interface charges that may exist between the dielectric layers themselves and between the passivation layer 130 and the semiconductor substrate 110. As used in the context of the first and second threshold voltages, the term "threshold voltage" is defined as the amount of voltage needed to deplete the electrons in the channel 107 in, e.g. first metal-semiconductor region 187 or in second metal-semiconductor region 189. In an embodiment, the first threshold voltage corresponding to the first metal-insulator semiconductor region may be between -10 volts and -80 V. In other embodiments, the first threshold voltage may be between -5 volts and -200 volts. In an embodiment, the second threshold voltage corresponding to the second metal-insulator semiconductor region may be between -30 volts and -100 V. In an embodiment, the field plate 180 may reduce the electric field and coupling and associated gate-drain capacitance between the gate electrode 150 and the drain electrode 145.

FIG. 2 is a cross-sectional, side view of an exemplary GaN heterojunction field effect transistor (HFET) 200, according to an embodiment. In an embodiment, the GaN HFET device 200 may include a semiconductor substrate 110, an isolation regions 120, an active region 125, a passivation layer 230, a source electrode 140, a drain electrode 145, a gate electrode 150, a first dielectric layer 260, a second dielectric layer 170, and a field plate 280. In an embodiment, the field plate 280 may contact the passivation layer 230 through a second opening 262 formed in the first dielectric layer 260, below a first opening 172 formed in the second dielectric layer 170. As is described in connection with the GaN HFET device 100 of FIG. 1, the GaN HFET device 200 may be substantially contained within the active region 125 defined by the isolation regions 120, with the passivation layer 230, the source electrode 140, the drain electrode 145, the gate electrode 150, the first dielectric layer 160, the second dielectric layer 170, and the field plate 280 disposed over the semiconductor substrate 110.

In an embodiment, the first dielectric layer 260 may include one of SiN, Al₂O₃, SiO₂, TEOS, HfO₂, ITO, diamond, poly-diamond, AlN, BN, SiC, or a combination of these or other insulating materials. In an embodiment, the thickness of the first dielectric layer 260 may be between about 50 angstroms and about 10,000 angstroms in thickness, although other thinner or thicker values may be used. In an embodiment, the first dielectric layer 260 may not include an etch stop layer so that the first dielectric layer may be completely etched to allow the passivation layer 230 to be exposed when the first and second openings 172 and 262 are formed.

In an embodiment, first and second openings 172 and 262 may be formed in the second and first dielectric layers 170, 260. Second opening 262 may be created in the first dielectric layer 260 formed beneath the first opening 172. The second opening 262 may allow the field plate 280 to contact the passivation dielectric 230, according to an embodiment. In an embodiment, the passivation layer 230 may include an etch-stop layer that allows the overlying first dielectric layer 160 to be etched selectively while enabling the passivation layer 230 to remain un-etched. For example, and according to an embodiment, the passivation layer 230 may include a multi-layer stack that provides functionality as a passivation layer and an etch-stop layer to allow selective etching of first dielectric layer 260. In an embodiment, the multi-layer stack may include a bottom passivating region, e.g. SiN or Al₂O₃, that contacts the semiconductor substrate 110, an intermediate region formed from the same or different dielectric material as the passivating region, e.g. SiN or Al₂O₃, and a final termination region, formed using, e.g. SiN or Al₂O₃. In some embodiments, the passivation layer 230 may include an Al₂O₃ passivating region formed over the semiconductor substrate followed by a SiN intermediate region formed over the Al₂O₃ passivating region, followed by an Al₂O₃ termination region that serves as an etch-stop. Without departing from the scope of the inventive subject matter, in other embodiments, alternate materials may be substituted for the passivating region intermediate region, and termination region. Such alternate materials may include SiO₂, SiO, diamond, boron nitride, HfO₂, AlN, and SiON.

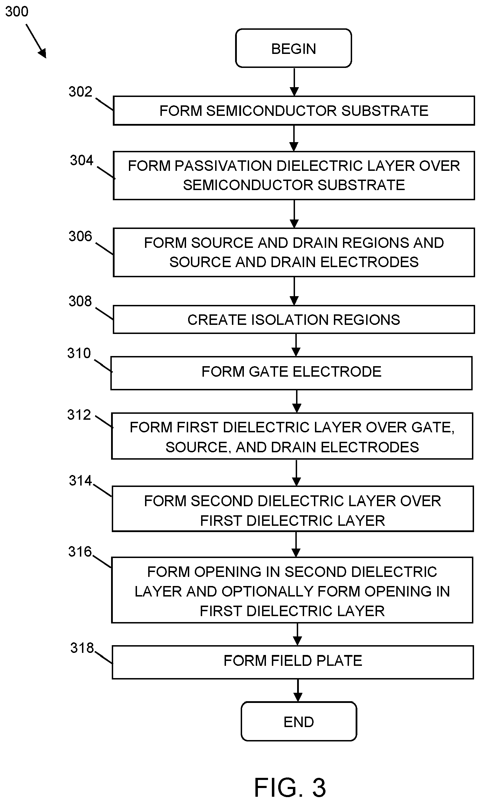

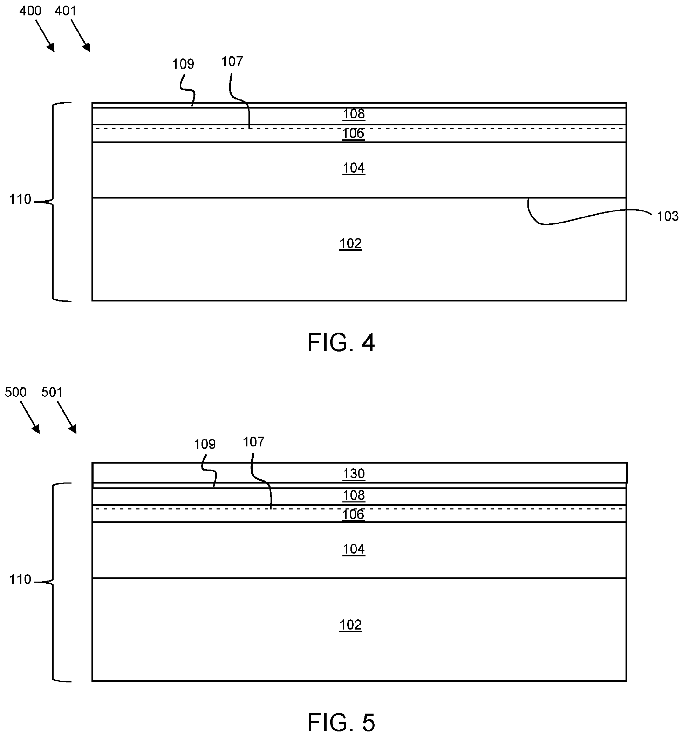

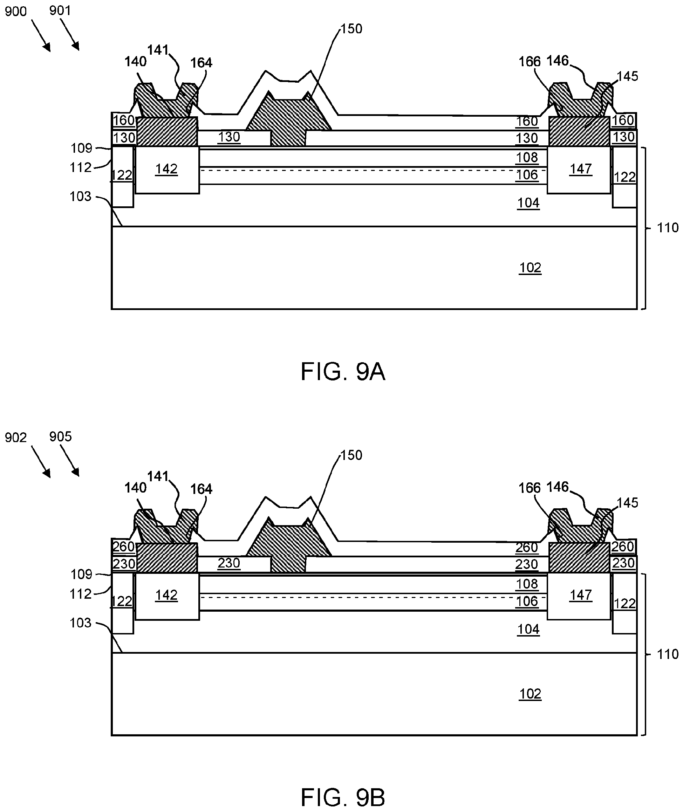

The flowchart 300 of FIG. 3 describes embodiments of methods for fabricating semiconductor devices (e.g. GaN HFET devices 100, 200 FIGs 1-2). FIG. 3 should be viewed alongside FIGs 4, 5, 6, 7, 8, 9, 10, 11, 12A, 12B, 13A, and 13B which illustrate cross-sectional, side views of a series of fabrication steps for producing the semiconductor devices of FIGs 1 and 2, in accordance with an example embodiment. For the sake of brevity while there are differences in some layers used in the initial stages of fabrication (e.g. passivation layers 130, 230) corresponding to the various embodiments, the partially completed views pertinent only to the GaN HFET 100 of FIG. 1 are shown up until the point where the differences in the methods for forming the embodiments require showing the specific fabrication steps for each embodiment as is the case in FIGs 9A, 9B, 10A, 10B, 11A, and 11B.

In block 302 of FIG. 3, and as depicted in the step 400 of FIG. 4, an embodiment of the method may include forming a semiconductor substrate 110. In an embodiment, the step 400 may include providing a host substrate 102 and forming number of semiconductor layers on or over the host substrate 102. In an embodiment, the host substrate 102 may include SiC, or may include other materials such as sapphire, Si, GaN, AlN, diamond, poly-SiC, silicon on insulator, GaAs, InP, or other substantially insulating or high resistivity materials. Forming the semiconductor layers may include forming a nucleation layer (not shown) on or over an upper surface 103 of the host substrate 102, forming a buffer layer 104 on or over the nucleation layer, forming the channel layer 106 on or over the buffer layer 104, forming the barrier layer 108 on or over the channel layer 106, and forming the cap layer 109 on or over the barrier layer 108. As discussed previously, embodiments of the buffer layer 104, the channel layer 106, the buffer layer 104, and the cap layer 109 may include materials selected from AlN, GaN, AlGaN, InAIN, InGaN, or other suitable materials. The semiconductor layers 104, 106, 108, and 109 may be grown using one of metal-organo chemical vapor deposition (MOCVD), molecular beam epitaxy (MBE), hydride-vapor phase epitaxy (HVPE) or a combination of these techniques, although other suitable techniques may alternatively be used. Semiconductor substrate 110 results. Structure 401 results.

In block 304 of FIG. 3, and as depicted in a step 500 of FIG. 5, an embodiment of the method may include forming a passivation layer 130 on or over the semiconductor substrate 110. As discussed previously, in an embodiment, the passivation layer 130 may include materials selected from SiN, Al₂O₃, SiO₂, AlN, and HfO₂. The passivation layer 130 may be formed using one or more of low pressure chemical vapor deposition (LPCVD), atomic layer deposition (ALD), sputtering, physical vapor deposition (PVD), plasma-enhance chemical vapor deposition (PECVD), MOCVD, MBE, inductively coupled plasma (ICP) deposition, electron-cyclotron resonance (ECR) deposition, or other suitable techniques. In other embodiments, the passivation layer 130 may be formed, *in-situ,* immediately after and in the same chamber or deposition system (e.g. MOCVD or MBE) as the growth of the semiconductor layers of semiconductor substrate 110. Structure 501 results.

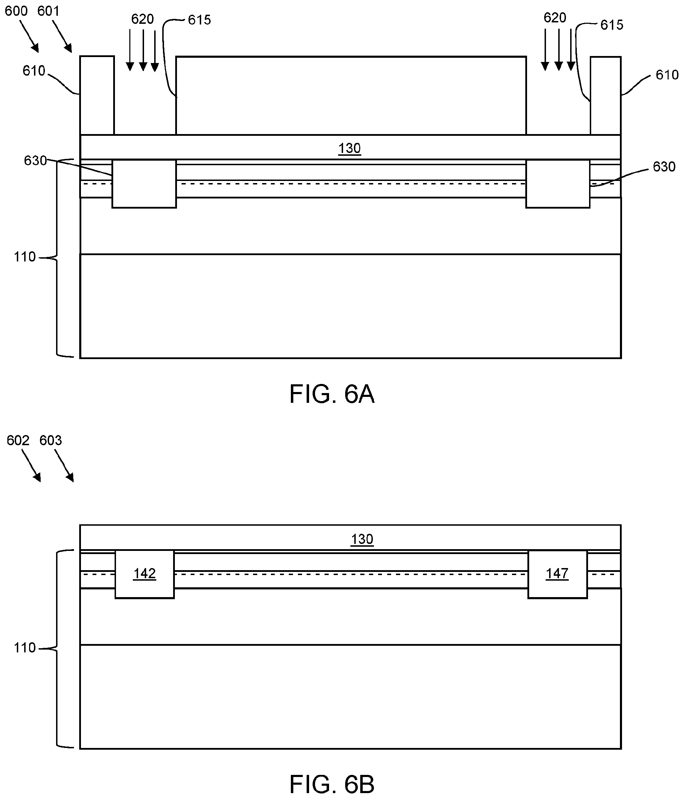

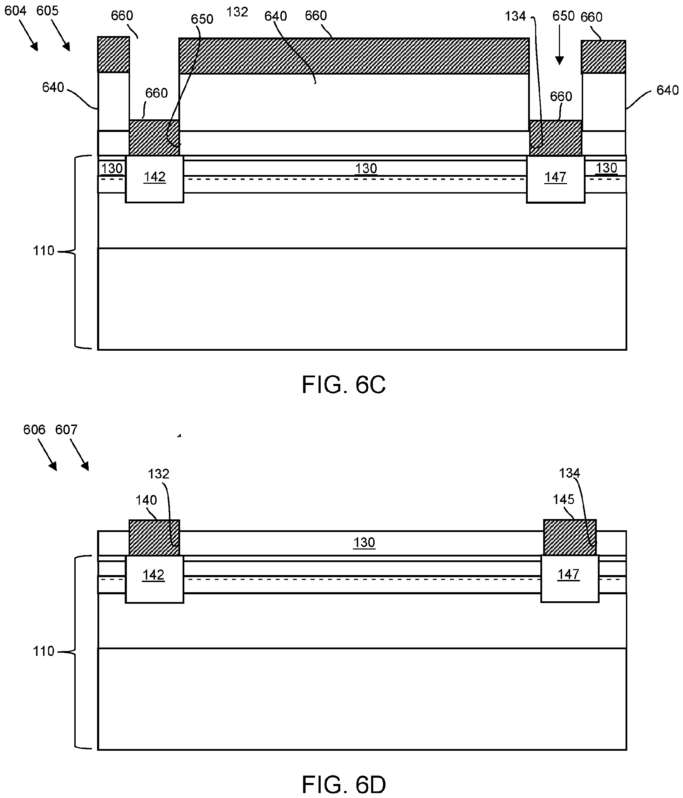

In block 306 of FIG. 3, and as depicted in steps 600, 602, 604, and 606 of FIGs 6A, 6B, 6C, and 6D, an embodiment of the method may include forming source and drain regions 142 and 147 in the passivation layer 130 and forming the source and drain electrodes 140 and 145. Referring again to FIG. 6A and step 600, an embodiment of the method may include patterning an implant mask 610 and implanting a dopant species 620 through an opening 615 in implant mask 610 into the semiconductor substrate 110 to form implant regions 630 within the semiconductor substrate 110. Once the implant mask layer is patterned, a dopant species may be implanted through the implant mask layer and into the semiconductor substrate. In an embodiment, Si, Ge, O, or other suitable n-type dopant may be implanted into the semiconductor substrate 110 through the implant mask 610. Structure 601 results.

Referring again to block 306 of FIG. 3 and step 602 and now to FIG. 6B, an embodiment of the method may include annealing to activate the dopant species to complete the formation of the source and drain regions 142 and 147 within the semiconductor substrate 110. In an embodiment where the implant mask 610 includes photo-resist, the implant mask 610 may be removed prior to the annealing step. In an embodiment where the implant mask 610 includes a dielectric layer (e.g. TEOS), the implant mask may be retained through the activation anneal step. According to an embodiment, the dopant species may be activated by annealing the semiconductor substrate 110 using an activation anneal at a temperature of between about 900°C and about 1500°C. Without departing from the inventive subject matter, in some embodiments, the passivation layer 130 may be stripped after implant anneal and then replaced with a passivation layer using similar techniques as described in the formation of passivation layer 130 in FIG. 5 (not shown). Structure 603 results.

In an embodiment, and referring to FIG. 6C, forming the source and drain openings 132, 134 and may include dispensing a resist layer 640 over the passivation layer 130 and patterning the resist layer 640 to form resist openings 650. In an embodiment, source and drain electrodes 140 and 145 may be created by etching through the passivation layer 130 in areas exposed by the resist openings 650 to form source and drain openings 132 and 134. Etching the passivation layer 130 (e.g. SiN) may include etching using one or more dry and/or wet etch technique(s) such as reactive ion etching (RIE), ICP etching, ECR etching, and wet chemical etching according to an embodiment. Suitable wet-etch chemistries may include hydrofluoric acid (HF), buffered HF, buffered oxide etch (BOE), phosphoric acid (H₃PO₄), or other suitable wet etchant(s), according to an embodiment. These dry etching techniques may use one or more of sulfur hexafluoride (SF₆), di-carbon hexafluoride (C₂F₆), carbon tetrafluoride (CF₄), trifluoromethane (CHF₃) or other suitable chemistry, to remove SiN, according to an embodiment. In an embodiment, the etchant used to etch the passivation layer 130 may selectively etch a portion of the passivation layer 130 and then stop on an etch-stop layer (not shown) (e.g. Al₂O₃ or AlN). In an embodiment, etching the etch-stop layer (e.g. an Al₂O₃ or AlN etch-stop layer) may include wet and/or dry etch techniques. In other embodiment(s), dry etching of the etch-stop layer (e.g. an AlN or Al₂O₃ etch-stop) may include dry etching using suitable techniques (e.g. RIE, ICP, or ECR) in conjunction chlorine-based chemistry such as Cl₂, boron trichloride (BCl₃), or other suitable dry-etch chemistries. Structure 605 results.

Referring again to block 306 of FIG. 3, and step 606 of FIG. 6C, an embodiment of the method may include forming and patterning source and drain electrodes 140 and 145 in source and drain openings 132 and 134. In an embodiment, the method may include depositing a metal layer 660 over the resist layer 640 and into the source and drain openings 132 and 134 formed by etching the passivation layer 130 exposed in the resist openings 650 formed in the resist layer 640. In an embodiment, the metal layer 660 may contain one or more metal layers that include Ti, Ta, Al, Mo, Au, Ni, Si, Ge, platinum (Pt), tungsten (W), and or other refractory metals, that when annealed, will form an ohmic contact with the source and drain regions 142, 147. In an embodiment, the metal layer 660 may include a stack deposited on the substrate that includes Ti, Al, and Au. In an embodiment, to form the metal layer 660, a Ti layer may be disposed over the semiconductor substrate 110 in the openings 650, an Al layer may be disposed over the Ti layer, a barrier layer formed from Mo or other suitable barrier metal such as Ni or tungsten, may be disposed over the Al layer, and an Au layer may be disposed over the barrier layer. In an embodiment, the metal layer 660 may be deposited by evaporation. In other embodiments, the metal layer 660 may be deposited by sputtering, PVD, or other suitable deposition techniques. In an embodiment, the Ti layer may be between about 100 angstroms and 200 angstroms thick, the Al layer may be between about 600 angstroms and 1500 angstroms thick, the Mo layer may be between about 200 angstroms and 700 angstroms thick, and the Au layer may be between about 300 angstroms and 1000 angstroms thick. In other embodiments, other metals may be substituted (e.g. Ni or Pt may be substituted for Mo or Ta may be added to or substituted for Ti) and other thicknesses may be used. In an embodiment, the resist layer 640 may be configured in a lift-off profile, wherein the openings of the resist layer 640 have a retrograde profile, allowing the metal not deposited into resist openings 650 to "lift off' when dissolved in solvents. In other embodiments (not shown), the source and drain electrodes 140 and 145 may be patterned by dry etching. Structure 605 results.

Referring again to block 306 of FIG. 3, and as depicted in step 606 of FIG. 6D, an embodiment of the method may include annealing source and drain electrodes 140 and 145 in source and drain openings 132 and 134. In an embodiment, annealing the source and drain electrodes 140 and 145 may include an annealing step used to alloy the metal layer 660 of FIG. 6C resulting in ohmic contacts to the source and drain regions 142 and 147 formed in semiconductor substrate 110 that form source and drain electrodes 140 and 145. In an embodiment, the annealing step may be accomplished by rapid thermal annealing. In an embodiment, the metal layer 660 of FIG. 6B that remains in source and drain openings 132 and 134 of FIG. 9B may be alloyed at a temperature of between about 500 degrees Celsius and 700 degrees Celsius for between about 15 seconds and about 60 seconds. In other embodiments the metal layer 660 of FIG. 6B may be annealed at between about 400 degrees Celsius and about 800 degrees Celsius for between about 10 seconds and about 600 seconds, though other higher or lower temperatures and times may be used. In an embodiment, the metal stack used to form metal layer 660 (e.g. Ti, Al, Mo, and Au) will mix to form the source and drain electrodes 140 and 145. Structure 607 results.

Without departing from the scope of the inventive subject matter, drain and source electrodes 140 and 145 may be formed using alloyed ohmic contacts (not shown). In these embodiments, source and drain regions may not be formed. Rather, ohmic contact to semiconductor substrate 110 may be accomplished by high temperature annealing of the ohmic metals (e.g. Ti, Al, Mo, Au may be used to form metal stack 660).

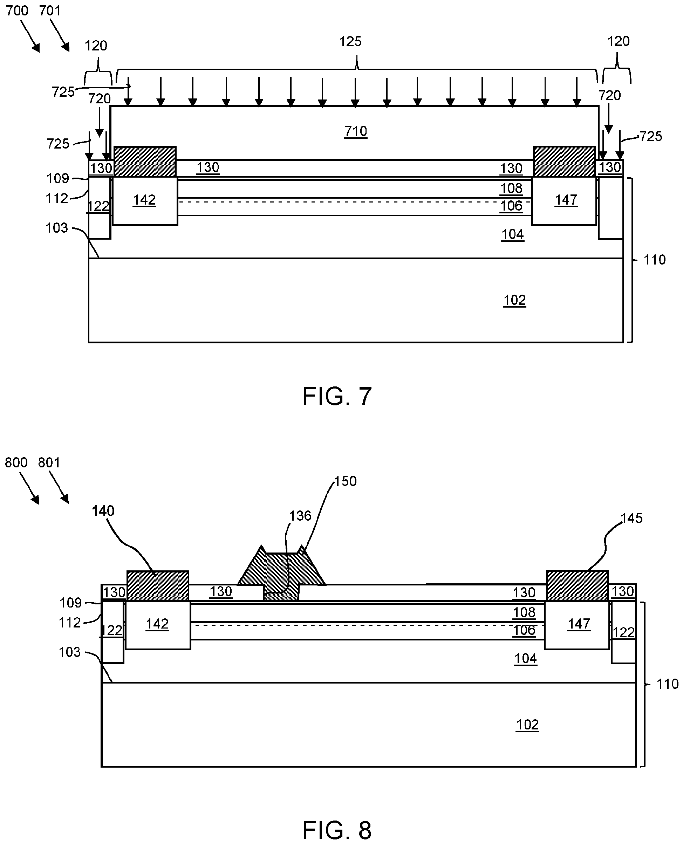

Referring again to block 308 and step 700 of FIG. 7, and in an embodiment, the method may include creating isolation regions 120. Forming the isolation regions 120 may include dispensing and patterning a resist mask 710 over the passivation layer 130 and then defining openings 720 in the resist mask 710. Using ion implantation, a dopant species 725 (e.g. one or more of oxygen, nitrogen, boron, and helium) may be driven into the semiconductor substrate 110 to create high resistivity regions 122. In an embodiment, the energy and dose of the implant may be configured to create a sufficient amount of damage in the crystal structure of the semiconductor substrate 110 such that the semiconductor substrate is substantially high resistivity or semi-insulating within the high resistivity regions 122 of the isolation regions 120. In other embodiments (not shown), forming the isolation regions 120 may include, first, etching some or all of the semiconductor layers in the semiconductor substrate 110 and then ion implanting to enhance the resistivity in the remaining semiconductor layers and/or the host substrate 102. Structure 701 results.

Referring next to block 310 of FIG. 3 and step 800 in FIG. 8, in an embodiment, forming the gate electrode 150 of the transistor devices 100, 200 of FIGs 1 and 2 may include forming a gate opening 136 in the passivation layer 130 and may include depositing and patterning a conductive material to form the gate electrode 150. In the embodiment shown, gate electrode 150 may be fabricated using the same conductive (e.g. metal) layer(s). In other embodiments (not shown), separate metal layers and processing steps may be used to form gate electrode 150.

In an embodiment of the method, photo resist or e-beam resist (not shown) may be patterned to create an opening in the resist in a manner analogous to the description given for FIG. 6C and step 604. Using the opening created in the resist layer, the passivation layer 130 may be etched to form gate opening 136, thus exposing a portion of the upper semiconductor substrate surface 112, according to an embodiment. In an embodiment, one or more layers of gate metal may then be deposited over the opening in the resist to form the gate electrode 150 over the upper semiconductor substrate surface 112 of the substrate 110 and the first field plate 160 over the passivation layer 130. Depositing gate metal to form the gate electrode 150 may include depositing a multi-layer stack that includes one or more metal layers and/or other suitable materials. In an embodiment, the various layers used to form gate electrode 150, as described in connection with the GaN HFET 100 of FIGs 1, 2 may be deposited by evaporation, sputtering, PVD, ALD, or other suitable deposition technique(s).

It should be appreciated that other methods may be used to form the gate electrode 150 without departing from the scope of the inventive subject matter. In methods for fabricating these other embodiments (not shown), the gate electrode 150 may be formed by patterning a first resist layer to form an opening, etching the passivation layer 130 to create an opening exposing the upper substrate surface 112 of the substrate 110, and then removing the first resist layer. In this embodiment, forming the gate electrode 150 may include patterning an opening in a second resist layer aligned over the opening created in the passivation layer 130 to expose the upper semiconductor substrate surface 112. The opening in the second resist layer may be smaller or larger than the opening in the passivation layer 130. In other embodiments, the gate electrode 150 may be disposed over a gate dielectric such as SiO₂, HfO₂, Al₂O₃, or similar materials such that the gate electrode 150 may not be in direct contact with the semiconductor substrate 110 (not shown). The gate dielectric may be deposited over and above the upper semiconductor substrate surface 112, according to an embodiment. In still other embodiments, the gate electrode 150 may be formed using gate metal that is deposited over the substrate 110 and is then defined by patterning photo resist, and then etching the gate metal. In whichever embodiment or method is selected to form gate electrode 150, gate metal may then be deposited using the methods described in connection with the formation of gate electrode 150 shown in FIG. 8.

Referring now to block 312 of FIG. 3, FIGs 9A, 9B and steps 900, 902 of the method of fabricating the transistor device 100 and 200 of FIGs 1 and 2 may further include depositing and patterning the first dielectric layer 160, 260 over the source and drain electrodes 140, 145, the gate electrode 150 and the passivation layer 130, 230 of structure 801 of FIG. 8, according to an embodiment. The first dielectric layer 160, 260 may be deposited using LPCVD, PECVD, sputtering, PVD, ALD, Cat-CVD, HWCVD, ECR CVD, CVD, ICP-CVD, a combination of these or other suitable dielectric deposition technique(s).

In an embodiment, additional process steps to etch the first dielectric layer 160, 260 may be analogous to those used to etch the passivation layer 130, 230 as described in connection with FIG. 6C, step 604, and may be used to create source and drain openings 164, 166 in the first dielectric layer 160, 260. In an embodiment, the first dielectric layer 160, 260 may be patterned by placing a resist layer (not shown) over the first dielectric layer 160, 260 and patterning the resist layer to form source and drain openings 164, 166 to portions of the first dielectric layer 160 over source and drain electrodes 140, 145. The first dielectric layer 160, 260 may then be etched through the openings in the resist layer to form source and drain openings 164, 166 using a technique analogous to the etching of the passivation layer 130, as described in connection with FIG. 6C, step 604 (not shown). In an embodiment, as described in connection with the GaN HFET device 100 of FIG. 1, where the first dielectric layer 160 includes an etch stop layer (e.g. Al₂O₃ or AlN) formed over an ILD layer (e.g. SiN or TEOS), etching the first dielectric layer 160 may include a F-based chemistry to etch an ILD layer (e.g. SiN) in the first dielectric layer 160, followed by a separate etch that may include Cl-based dry etch or other appropriate etchant to etch the etch stop (e.g. Al₂O₃). In an embodiment, as described in connection with the GaN HFET device 200 of FIG. 2, the first dielectric layer 260 may not include an etch stop layer and the etch may stop on the passivation layer 230 as a second opening 262 is formed in the first dielectric layer 260. For example, and in an embodiment, F-based chemistry may be used to etch the first dielectric layer 260 that may include a single SiN or TEOS layer(s) and may stop on the source and drain electrodes 140, 145. In an embodiment, additional metallization regions 141, 146 may be formed within source and drain openings 164, 166 to contact source and drain electrodes 140, 145. Structures 901 and 905 result.

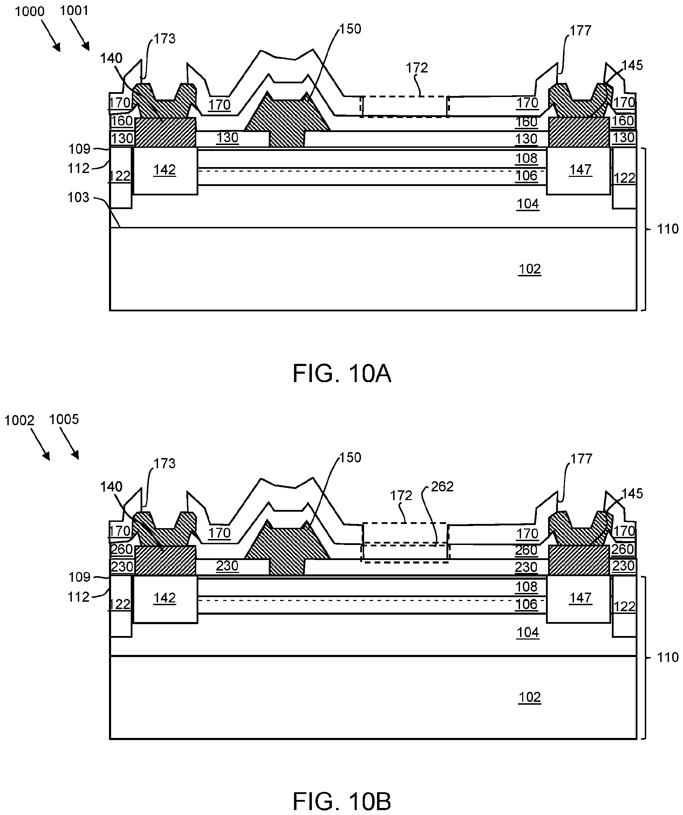

Referring now to blocks 314, 316 of FIG. 3, FIGs 10A, 10B and steps 1000, 1002, the method of fabricating the transistor device 100 and 200 of FIGs 1 and 2 may further include depositing and patterning the second dielectric layer 170 over the first dielectric layer 160, 260 of structures 901, 905 of FIGs 9A and 9B, according to an embodiment. In an embodiment, the second dielectric layer 170 may be deposited using LPCVD, PECVD, sputtering, PVD, ALD, Cat-CVD, HWCVD, ECR CVD, CVD, ICP-CVD, a combination of these or other suitable dielectric deposition technique(s).

In an embodiment, additional process steps to etch the second dielectric layer 170 may be analogous to those used to etch the passivation layer 130 as described in connection with FIG. 6C, step 604, and may be used to create first opening 172 and source and drain openings 173, 177. The second dielectric layer 170 may then be etched through the openings using a technique analogous to the etching of the passivation layer 130, as described in connection with FIG. 6C, step 604. In an embodiment, the second dielectric layer 170 may be patterned by forming a resist layer (not shown) over the first dielectric layer 160, and patterning the resist layer to form openings 173, 177 in portions of the second dielectric layer 170 over source and drain electrodes 140, 145. In an embodiment, openings 173, 177 are formed using the same masking layer as used to form the first opening 172. In other embodiments, separate masking layers may be used to form openings 173, 177 and the first opening 172. In an embodiment as described in connection with GaN HFET device 100 of FIG. 1, the etching of the first opening 172 in the second dielectric layer 170 (e.g. F-based dry etching) may stop on an etch stop region of first dielectric layer 160 (e.g. Al₂O₃ etch stop layer). In an embodiment, as described in connection with the GaN HFET device 200 of FIG. 2, the first dielectric layer 260 may not include an etch stop layer and the etch may stop on the passivation layer 230 as a second opening 262 is formed in the first dielectric layer 260. For example, and in an embodiment, F-based chemistry may be used to etch the first dielectric layer 260 that may include a single SiN or TEOS layer(s) and may stop on an Al-containing etch stop layer in the passivation layer 230. Structures 1001, 1005 result.

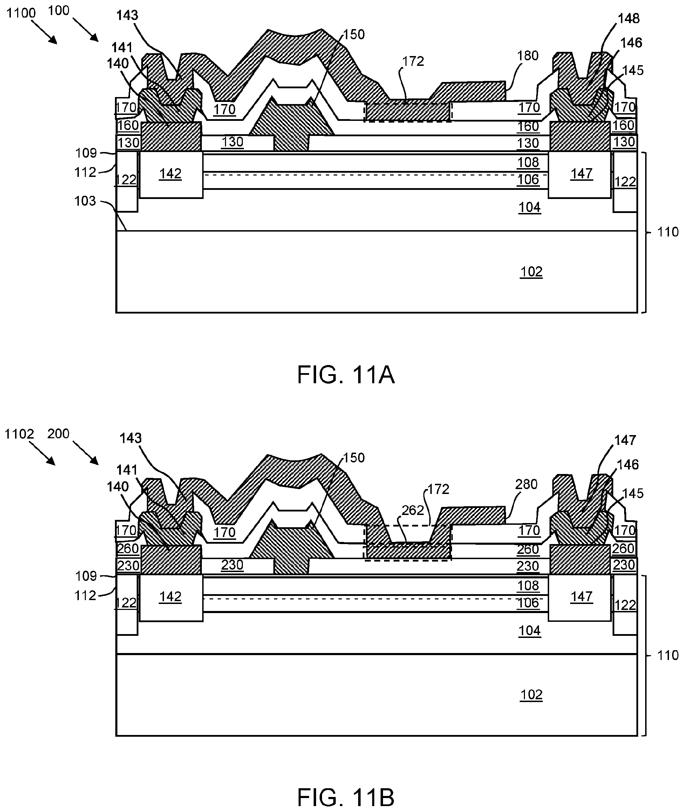

Referring now to block 318 of FIG. 3, FIGs 11A and 11B and steps 1100, 1102, the method of fabricating the transistor structures of GaN HFET device 200 of FIG. 2 may further include depositing and patterning the field plate 180, 280 and source and drain metallization 143, 148 over the second dielectric layer 170 and source and drain electrodes 140, 145 of structures 1001, 1005 of FIGs 10A and 10B, according to an embodiment. In an embodiment, forming and patterning the field plate 180, 280 and source and drain metallization 143, 148 may be accomplished by applying and patterning resist layers (not shown), depositing the field plate 180, 280, source and drain metallization 143, 148 and removing the resist layers and overlying metal outside the field plate 180, 280, source and drain metallization 143, 148, and other structures (e.g. interconnects, not shown) in a lift-off configuration, analogous to step 700 in FIG. 7. In an embodiment, the field plate metal may be formed by depositing one or more adhesion and conductive metal layers into openings (not shown) patterned into resist layers applied to the partially-formed device as described above. In an embodiment, the adhesion layer(s) may be deposited first, followed by deposition of the conductive layer(s). In an embodiment, the adhesion and conductive layers may be deposited in the same deposition step. The adhesion and conductive layers used to form the field plate metal 180, 280 may be deposited over and in contact with the second dielectric layer 170 and the first dielectric layer 160, 260 according to the embodiment of FIG. 11A. The adhesion and conductive layers used to form the field plate metal may be deposited over and in contact with the second dielectric layer 170 and the first dielectric layer 260 and passivation layer 230 according to an embodiment of FIG. 11B. In an embodiment, the adhesion layer(s) and conductive layer(s) may be formed by sputtering, evaporation, or electro-plating. In an embodiment, after applying and patterning resist layers and depositing the field plate 180, 280, the resist layers and metals deposited over the resist layers and not included with the portions of the field plate metal that contact the second dielectric layer 170 and first dielectric layer 160, 260, and passivation layer 130 are removed using solvents analogous to those described in conjunction step 604 in FIG. 6C. In other embodiments, the field plate metal may be formed by depositing adhesion and conductive layers that are then patterned by suitable dry or wet chemical etching techniques. Completed GaN HFET devices 100, 200 result.

An embodiment of a semiconductor device includes a semiconductor substrate, a first current-carrying electrode, and a second current-carrying electrode formed over the semiconductor, a control electrode formed over the semiconductor substrate between the first current carrying electrode and the second current carrying electrode, and a first dielectric layer disposed over the control electrode, and a second dielectric layer disposed over the first dielectric layer. A first opening is formed in the second dielectric layer, adjacent the control electrode and the second current-carrying electrode, having a first edge laterally adjacent to and nearer the second current-carrying electrode, and a second edge laterally adjacent to and nearer to the control electrode, and a conductive element formed over the first dielectric layer and within the first opening, wherein the portion of the conductive element formed within the first opening forms a first metal-insulator-semiconductor region within the first opening.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

For the sake of brevity, conventional semiconductor fabrication techniques may not be described in detail herein. In addition, certain terminology may also be used herein for reference only, and thus are not intended to be limiting, and the terms "first," "second," and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

## Claims

1. A semiconductor device comprising:
a semiconductor substrate that includes an upper surface and a channel;
a first current-carrying electrode and a second current-carrying electrode formed over the semiconductor substrate, wherein the first current-carrying electrode and the second current-carrying electrode are electrically coupled to the channel;
a control electrode formed over the semiconductor substrate between the first current carrying electrode and the second current carrying electrode, wherein the control electrode is electrically coupled to the channel;
a first dielectric layer disposed over the control electrode;
a second dielectric layer disposed over the first dielectric layer;
a first opening formed in the second dielectric layer, adjacent the control electrode, and between the control electrode and the second current-carrying electrode having a first edge laterally adjacent to and nearer the second current-carrying electrode, and a second edge laterally adjacent to and nearer the control electrode; and
a conductive element formed over the first dielectric layer and within at least a portion of the first opening, wherein the portion of the conductive element formed within the first opening forms a first metal-insulator-semiconductor region that includes the portion of the conductive element formed within the first opening, the first dielectric layer, and the semiconductor substrate.

2. The semiconductor device of claim 1, wherein the first dielectric layer includes an etch-stop layer formed over an interlayer dielectric layer, wherein the interlayer dielectric layer is selected from the group consisting of silicon nitride, silicon dioxide, silicon oxynitride, silicon oxide, hafnium oxide, and tetra-ethyl ortho silicate.

3. The semiconductor device of any preceding claim, wherein the first dielectric layer includes an interlayer dielectric layer formed over an etch-stop layer, wherein the interlayer dielectric layer is selected from the group consisting of silicon nitride, silicon dioxide, silicon oxynitride, silicon oxide, hafnium oxide, and tetra-ethyl ortho silicate.

4. The semiconductor device of any preceding claim, wherein the second dielectric layer is selected from the group consisting of silicon nitride, silicon dioxide, silicon oxynitride, silicon oxide, hafnium oxide, and tetra-ethyl ortho silicate.

5. The semiconductor device of any preceding claim, wherein a portion of the conductive element formed between the second current-carrying electrode and the first edge of the first opening forms a second metal-insulator-semiconductor region that includes the portion of the conductive element between the second current-carrying electrode and the first edge of the first opening, the second dielectric layer, the first dielectric layer, and the semiconductor substrate.

6. The semiconductor device of claim 5 further comprising:
a passivation layer disposed over the upper surface of the semiconductor substrate, between the first dielectric layer and the semiconductor substrate.

7. The semiconductor device of claim 6 wherein the passivation layer includes silicon nitride.

8. The semiconductor device of claim 6 or 7, further comprising a second opening formed in the first dielectric layer, wherein the second opening overlaps at least a portion of the first opening, and wherein at least a portion of the conductive element is formed within the second opening, wherein the portion of the conductive element formed within the second opening contacts the passivation layer.

9. The semiconductor device of any of claims 6 to 8, further comprising passivation openings formed in the passivation layer that surround the first current-carrying electrode and the second current-carrying electrode.

10. The semiconductor device of claim 9, wherein the first current-carrying electrode is configured as a source electrode, the second current-carrying electrode is configured as a drain electrode, the control electrode is configured as a gate electrode, and the conductive element is configured as a field plate.

11. The semiconductor device of claim 10, wherein a lateral distance between the gate electrode and the first opening is between 0.2 microns and 2 microns.

12. The semiconductor device of any of claims 10 or 11, wherein the field plate is electrically coupled to a potential of the source electrode.

13. A gallium nitride heterojunction field effect transistor device comprising the semiconductor device of any of claims 10 to 12, and a semiconductor substrate that includes a gallium nitride layer.

14. The gallium nitride heterojunction field effect transistor device of claim 13, further comprising a second opening formed in the first dielectric layer, wherein the second opening overlaps at least a portion of the first opening, and wherein at least a portion of the field plate is formed within the second opening, wherein the portion of the field plate formed within the second opening contacts the passivation layer.

15. A method of fabricating a gallium nitride heterojunction field effect transistor device comprising:
forming a semiconductor substrate that includes a gallium nitride layer, a channel, and an upper surface;
forming a passivation layer over the upper surface of the semiconductor substrate;
forming passivation openings in the passivation layer;
forming a source electrode and a drain electrode over the semiconductor substrate within the passivation openings formed in the passivation layer, wherein the source electrode and the drain electrode are in ohmic contact with the channel and configured to support current flow from the source electrode to the drain electrode;
forming a gate electrode over the semiconductor substrate between the source electrode and the drain electrode, wherein the gate electrode is electrically coupled to the channel and is configured to control current flow from the source electrode to the drain electrode;
forming a first dielectric layer over the gate electrode and the passivation layer;
forming a second dielectric layer over the first dielectric layer;
forming a first opening in the second dielectric layer, adjacent the gate electrode and between the gate electrode and the drain electrode, having a first edge laterally adjacent to and nearer the second current-carrying electrode, and a second edge laterally adjacent to and nearer the gate electrode; and
forming a field plate over the second dielectric layer, wherein at least a portion of the field plate is formed within the first opening.
